# EUROPÄISCHE PATENTSCHRIFT

(11) **EP 0 525 350 B1**
(45) Veröffentlichungstag und Bekanntmachung des Hinweises auf die Patenterteilung: **12.03.1997**
(21) Anmeldenummer: 92110015.2
(22) Anmeldetag: 13.06.1992
(51) Int. Cl.: G05B 23/02, G01R 31/28

(54) **Verfahren und Vorrichtung zur Prüfung von Steuergeräten**
Method and arrangement for testing control apparatus
Procédé et dispositif pour tester des appareils de commande

(30) Priorität: 29.06.1991 DE 4121637
(43) Veröffentlichungstag der Anmeldung: 03.02.1993
(73) Patentinhaber: ROBERT BOSCH GMBH, 70442 Stuttgart (DE)
(72) Erfinder: Horbel, Michael, Dipl.-Ing. (FH), W-7120 Bietigheim (DE); Seitel, Hans, Dipl.-Ing., W-7302 Ostfildern 1 (DE); Hoenninger, Harald, Dipl.-Phys., W-7800 Freiburg (DE); Pruellage, Arno, Dipl.-Ing. (FH), W-7141 Schwieberdinger (DE)

(56) Entgegenhaltungen:
- DE-A- 3 632 569
- DE-A- 3 904 891
- GB-A- 2 212 638
- JP-A-63 269 238
- US-A- 4 339 801

## Beschreibung

### Stand der Technik

Die Erfindung geht aus von einem Verfahren zur Prüfung von Steuergeräten, sowie einer Vorrichtung zur Durchführung des Verfahrens nach der Gattung des Hauptanspruchs. Es ist schon ein Verfahren zur Überprüfung von elektrischen Schaltungen aus der DE-OS 36 32 569 bekannt. Dabei werden die einzelnen Ein- und/oder Ausgänge des Steuergerätes in einzelnen Prüfschritten separat geprüft. Dies geschieht mit Hilfe einer Simulations- und Meßeinrichtung, die bestimmte Signale an die Eingänge des Steuergerätes legt. Diese werden sodann von einem im Speicher des Steuergerätes abgelegten Testprogramm abgefragt. Die vom Testprogramm ermittelten Werte werden dann - nach Aufforderung durch einen an das Steuergerät und an die Simulations- und Meßeinrichtung angeschlossenen Prüfrechner - an diesen über eine Schnittstelle übermittelt und dort auf Richtigkeit geprüft. Gegebenenfalls löst der Prüfrechner dann eine Fehlermeldung aus. Ebenfalls gibt der Prüfrechner dem Steuergerät bestimmte Werte über die Schnittstelle vor und fordert das Steuergerät auf, diese Werte an bestimmte Ausgänge auszugeben. Mit den in der Simulations- und Meßeinrichtung vorhandenen Meßgeräten prüft dann der Prüfrechner diese Werte auf Richtigkeit. Liegen die Werte nicht im vorgegebenen Sollwertbereich, so löst der Prüfrechner eine Fehlermeldung aus.

Die Durchführung des Prüfverfahrens benötigt viel Zeit, da die einzelnen Ein- und Ausgänge separat geprüft werden und vor jeder Abarbeitung eines Prüfschrittes durch das Testprogramm eine bestimmte Wartezeit einzuhalten ist, während derer der Prüfrechner die Eingänge anderweitig beschalten kann.

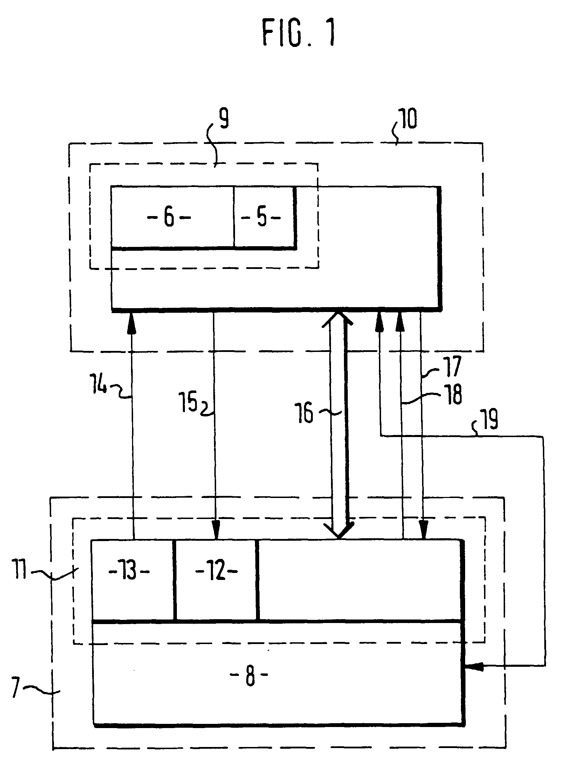

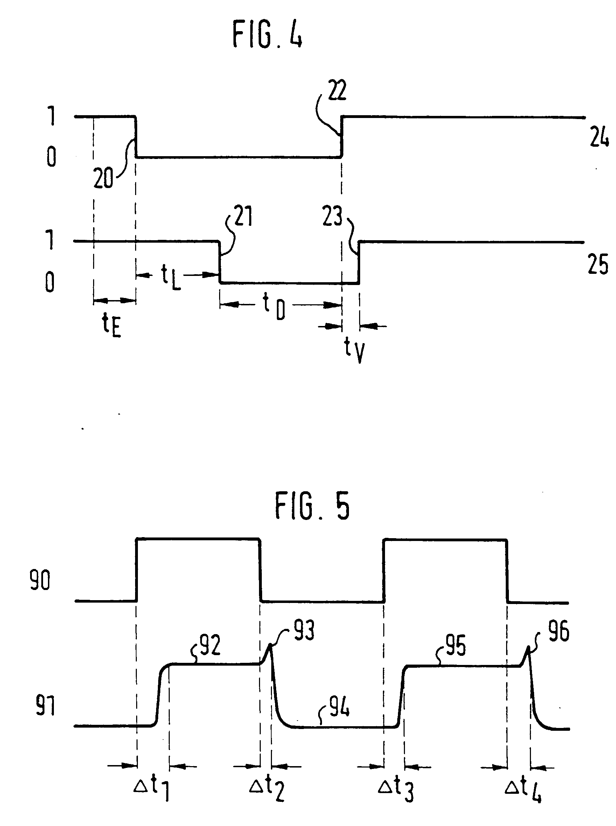

Aus der GB 22 44 161 ist eine Mikroprozessoreinheit und eine Testeinheit bekannt. In der Figur 1 wird dabei ein Aufbau gezeigt, bei dem die Eingangsleitungen des zu testenden Geräts mit den Werten beaufschlagt werden, mit denen sie auch im Nutzbetrieb beaufschlagt werden und die Ausgänge des zu testenden Geräts ausschließlich die Meßwerte ausgeben, die sie auch beim Nutzbetrieb ausgeben. Es werden somit keinerlei weiterer Eingangs- und Ausgangsleitungen beschrieben. In der Figur 5 wird eine weitere Leitung beschrieben, die als serielle Schnittstelle ausgebildet ist und nur zu Testzwecken, insbesondere zum Laden eines Testprogramms, verwendet wird.

Das erfindungsgemäße Verfahren bzw. die erfindungsgemäße Prüfeinrichtung nach der Gattung der unabhängigen Patentansprüche weist demgegenüber den Vorteil auf, daß Leitungen mehrfach zu unterschiedlichen Zwecken während des Testprogramms bzw. während des Nutzprogramms genutzt werden. Es wird somit ein Prüfverfahren bzw. eine Prüfeinrichtung angegeben welches mit erhöhter Prüfgeschwindigkeit arbeitet und gleichzeitig keinen zusätzlichen Hardwareaufwand erfordert.

Weiterhin ist es vorteilhaft, wenn die Abarbeitung der Prüfschritte ereignisgesteuert ist. Dies ermöglicht eine Reduzierung der Prüfzeitdauer. Diese wirkt sich vorteilhaft in der Produktion der Steuergeräte aus. Damit läßt sich ebenfalls eine dynamische Messung von Eingangssignalen wie das Einschwingverhalten durch Variation der Zeit zwischen Anlegung der Signale an das Steuergerät und dem Signal zur Aufforderung der Verarbeitung der angelegten Signale erreichen. Als weiterer Vorteil ist anzusehen, daß mehrere Ein- und/oder Ausgänge gleichzeitig getestet werden können. Dies reduziert ebenfalls die Dauer der Prüfung. Bis auf den Eingang für die Ereignissteuerung können alle Eingänge zur Prüfung mit Signalen belegt werden. Es können unterschiedliche Anzahlen von Ein- und/oder Ausgängen in einem Prüfschritt getestet werden, so daß das Verfahren sehr variabel eingesetzt werden kann. Die Anzahl der Prüfschritte kann ebenfalls variiert werden und ist nur durch die Größe des flüchtigen Speichers im Steuergerät begrenzt. Als weiterer Vorteil ist anzusehen, daß die Verarbeitung der an das Steuergerät angelegten Signale unabhängig von dem Nutzprogramm des Steuergerätes stattfindet. Dies ermöglicht, daß das Verfahren leicht an unterschiedliche Steuergeräte angepaßt werden kann. Dabei brauchen nur die Soll-Werte an den vielleicht unterschiedlichen Aufbau angepaßt zu werden. Für den Fall, daß nur die Daten und/oder Programme des Steuergerätes geändert wurden, ist keine Anpassung der prüfeinrichtung notwendig. Die Auswahl der an das Steuergerät anzulegenden Meßwerte ist nicht mehr auf den - vom Nutzprogramm vorgegebenen - Wertebereich der Ein- und Ausgangsgrößen beschränkt und kann dann in der Prüfvorschrift an den Bedürfnissen des Aufbaus der Steuergeräte ausgerichtet werden. Ebenfalls ist es möglich, die sich aus den physikalischen Gegebenheiten des Steuergerätes ergebenden Eingangsgrößen für das Steuergeräteprogramm direkt zu bestimmen und zu nutzen. Als weiterer Vorteil ist anzusehen, daß das Zeitverhalten bestimmter an das Steuergerät angelegter und vom Steuergerät sofort ausgegebener alternierender Signale, insbesondere Rechtecksignale gemessen und ausgewertet wird. Damit wird eine Vergrößerung der Prüftiefe erreicht. Außerdem ermöglicht dies die Erfassung von Abschaltspitzen und Sättigungsspannungen der ausgegebenen Signale. Die Zuordnung der an bestimmte Eingänge angelegten alternierenden Signale zu bestimmten Ausgängen ist nicht fest vorgegeben, sondern kann teilweise ausgewählt werden.

Durch die in den Unteransprüchen aufgeführten Maßnahmen sind vorteilhafte Weiterbildungen und Verbesserungen des im Hauptanspruch angegebenen Verfahrens möglich. Besonders vorteilhaft ist, während der Einleitung der Prüfung an bestimmte Eingänge des Steuergerätes mindestens ein, im normalen Nutzbetrieb unplausibles, Signal anzulegen, das vom Testprogramm erfaßt und auf Richtigkeit geprüft wird und bei Unrichtigkeit zum Abbruch des Testprogramms führt. Damit wird ein versehentlicher Einstieg in das Testprogramm erschwert. Noch günstiger wird ein Einstieg verhindert, wenn zu Beginn der Prüfung eine Initialisierung des Steuergerätes vorgenommen wird, wobei vom Testprogramm bestimmte Daten auf einen freien Speicherplatz des Speichers des Steuergerätes und/oder in bestimmte Register des Steuergerätes gespeichert werden, daß während des Ablaufs der Prüfung vom Testprogramm der Inhalt des Speicherplatzes und/oder der Register auf Richtigkeit überprüft wird und daß bei Unrichtigkeit des auf dem Speicherplatz und/oder der Register abgelegten Werte ein Abbruch des Testprogramms erfolgt.

Zur Durchführung des Verfahrens ist eine Prüfeinrichtung vorgesehen, die eine bestehende Simulations- und Meßeinrichtung verwendet. Der Simulationsteil der Simulations- und Meßeinrichtung enthält Widerstandsdekaden Schalter sowie Signalgeneratoren, mit deren Hilfe unterschiedliche Werte an die Eingänge der Steuergeräte angelegt werden können und über steuerbare Relais den verschiedenen Eingängen zugeführt werden können. Als Meßgeräte können Digitalvoltmeter, Oszilloskope, Transientenspeicher sowie Frequenzzähler Verwendung finden. Zur Umwandlung analoger Eingangsgrößen sowie zur Ausgabe analoger Signale ist es vorteilhaft, die Ein-Ausgangsschaltungen der Steuergeräte sowie der Simulations- und Meßeinrichtung mit Analog-Digitalwandlern und Digital-Analogwandlern aufzubauen. Zur Anforderung einzelner Prüfschritte von Hand ist es vorteilhaft, die Simulations- und Meßeinrichtung mit einer Handsteuereinheit auszustatten.

### Zeichnung

Ein Ausführungsbeispiel der Erfindung ist in der Zeichnung dargestellt und in der nachfolgenden Beschreibung näher erläutert. Es zeigen Figur 1 eine Anordnung zur Prüfung von Steuergeräten, Figur 2 die Programmstruktur des im Programmspeicher des Prüfrechners abgelegten Prüfprogrammes, Figur 3 die Programmstruktur des im Programmspeicher des Steuergerätes abgelegten Testprogramms, Figur 4 ein Signaldiagramm zweier Steuerleitungen zur Ablaufsteuerung der Prüfung, und Figur 5 ein Signaldiagramm zweier Steuerleitungen der Anordnung zur Prüfung des Steuergerätes mit Hilfe von Rechtecksignalen.

### Beschreibung der Erfindung

Die in Figur 1 dargestellte Anordnung zur Prüfung von Steuergeräten weist eine Prüfeinrichtung 7 und ein Steuergerät 10 auf. Die Prüfeinrichtung 7 enthält einen Prüfrechner 8 und eine Simulations- und Meßeinrichtung 11. Die Simulations- und Meßeinrichtung 11 beinhaltet ein Digitalvoltmeter 12, einen Rechteckgenerator 13 und weitere Meßgeräte wie z. B. Frequenzzähler und Oszilloskope. Im Steuergerät 10 befindet sich ein Programmspeicher 9 mit einem flüchtigen Teil 5 und einem nichtflüchtigen Teil 6. Von dem Rechteckgenerator 13 geht eine im normalen Nutzbetrieb als Drehzahleingangsleitung verwendete Leitung 14 zum Steuergerät 10. Von dem Steuergerät 10 führt eine im normalen Nutzbetrieb als Diagnoselampe-Ausgangsleitung verwendete weitere Leitung 15 zu dem Digitalvoltmeter 12. Weitere Ein-, Ausgangsleitungen 16 sind an das Steuergerät 10 und an die Simulations- und Meßeinrichtung 11 angeschlossen. Zur Datenübertragung von und zum Steuergerät 10 ist an den Prüfrechner 8 und das Steuergerät 10 ein serieller Bus 19 angeschlossen. Von dem Steuergerät 10 geht eine im normalen Nutzbetrieb als Zündsignalausgangsleitung verwendete Steuerleitung 17 zur Simulations- und Meßeinrichtung 11. Von der Simulations- und Meßeinrichtung 11 geht ein als Leerlaufkontakteingangsleitung verwendete Steuerleitung 18 zum Steuergerät 10.

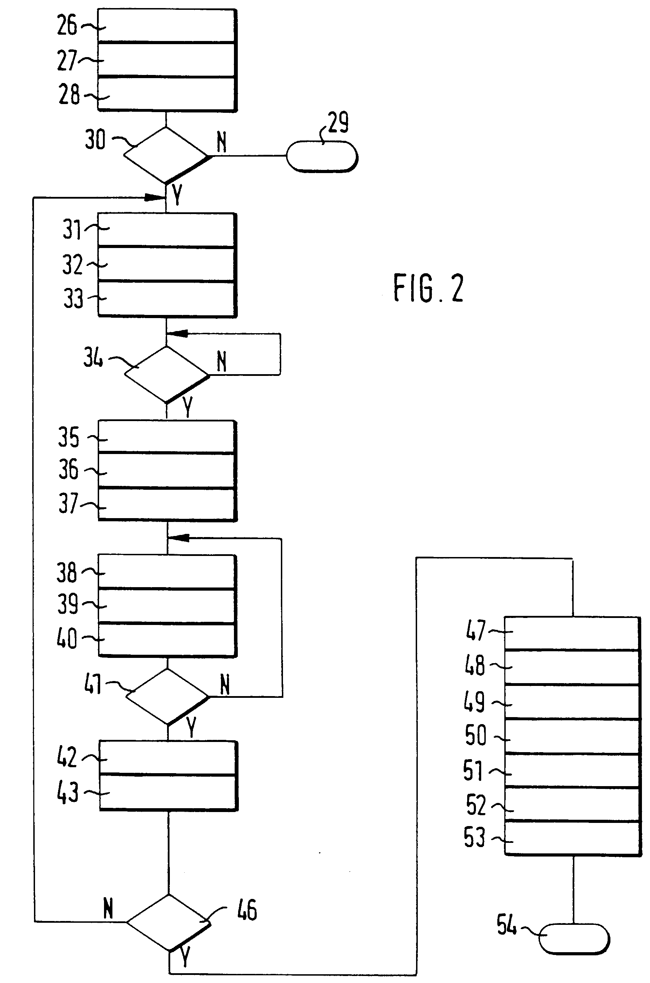

Die Wirkungsweise der Anordnung zur Prüfung von Steuergeräten wird nachfolgend anhand der Figuren 2 - 5 erklärt. Das in Figur 2 dargestellte Struktogramm soll den Ablauf der Prüfung seitens der Prüfeinrichtung 7 verdeutlichen. Nachdem das Steuergerät 10 mit der Prüfeinrichtung 7 über dafür vorgesehene Steckverbinder verbunden wurde, baut der Prüfrechner 8 nach dem Start des Prüfprogramms die Kommunikation mit dem Steuergerät 10 über den seriellen Bus 19 auf. Dies geschieht im Programmschritt 26 durch einen Reizvorgang mit einer 5 Baud-Adresse, worauf das Steuergerät 10 durch Senden seines Baudraten-Erkennungsbytes sowie weiterer Informationsblöcke antwortet. Am Ende des Reizverfahrens wird auch die Steuergeräte-Identifikationsnummer an den Prüfrechner übermittelt.

Sie wird im Prüfrechner dazu benutzt, das für diesen Steuergerätetyp gültige Prüfprogramm mit den entsprechenden Sollwerten und Meßwerten auszuwählen. In diesem Programmschritt wird ebenfalls ein Prüfschrittzähler auf einen definierten Startwert z. B. Null gesetzt. Kann die Kommunikation mit dem Steuergerät 10 nicht ordnungsgemäß aufgebaut werden, so wird das Steuergerät entfernt und weiteren Prüfungen unterzogen.

Konnte die Kommunikation erfolgreich aufgebaut werden, so fordert der Prüfrechner 8 in dem Programmschritt 27 das Steuergerät 10 auf, vom Nutzprogramm in das im Steuergerät 10 abgelegte Testprogramm zu verzweigen und legt dazu im Programmschritt 28 mit Hilfe der in der Simulations- und Meßeinrichtung 11 vorhandenen Signalgeneratoren an den Drehzahleingang 14 des Steuergerätes 10 ein Drehzahlsignal mit einer Frequenz von 266,6 Hz entsprechend einer Motordrehzahl von 8000 1/min und an den Geschwindigkeitseingang des Steuergerätes 10 ein Geschwindigkeitssignal mit einer Frequenz von 133,3 Hz entsprechend der halben Motordrehzahl an. Diese Signale sind so ausgewählt, daß sie im normalen Nutzbetrieb des Steuergerätes nicht vorkommen können. Es könnten hier auch weitere Signale wie ein geschlossener Leerlaufkontakteingang 18 gleichzeitig angelegt werden, um eine weitere Absicherung gegen eine unbeabsichtigte Prüfungseinleitung zu erzielen. Diese Eingänge werden sodann vom Testprogramm des Steuergerätes 10 abgefragt. Stellt das Testprogramm die Werte an sich als richtig sowie das Verhältnis von Drehzahlsignal zu Geschwindigkeitssignal als 2 fest, so liefert das Steuergerät 10 eine Rückmeldung vom Prüfrechner 8 über den seriellen Bus 19 als Zeichen zur Prüfbereitschaft. Programmschritt 30 stellt die Abfrage, ob die Prüfbereitschaft vorliegt, dar. Andernfalls erfolgt diese Meldung nicht und das Prüfprogramm im Prüfrechner beendet den Prüfvorgang und gibt eine Fehlermeldung aus (Programmschritt 29). In dem Programmschritt 31 wird sodann der Prüfschrittzähler inkrementiert. Der erste Prüfschritt wird dann von dem Prüfrechner 8 vorbereitet. Dies geschieht in dem Programmschritt 32. Darin legt der Prüfrechner 8 mit Hilfe der Simulations- und Meßeinrichtung 11 einen Satz von Eingangssignalen an die Eingangsleitungen des Steuergerätes 10 an. Dabei wird derjenige Satz von Eingangssignalen aus einer Tabelle im Prüfprogramm ausgewählt, der zu dem durch den Prüfschrittzähler gekennzeichneten Prüfschritt gehört. Der Satz von Eingangssignalen wird mit Hilfe der in der Simulations- und Meßeinrichtung 11 vorhandenen Signalgeneratoren erzeugt.

Dabei kann der Satz von Eingangssignalen sehr variabel gestaltet sein. D. h., es könnten z. B. nur an einem Eingang ein zeitunabhängiges Signal angelegt werden, während die anderen Eingänge auf Masse geschaltet werden. Ebenso ist es aber auch möglich, an alle Eingänge zeitunabhängige Signale auszugeben, wobei kein Eingang auf Masse gezogen wird. Desweiteren müssen die Signale nicht zeitunabhängig sein, sie können vielmehr auch zeitabhängig wie z. B. ein Rechtecksignal mit bestimmter Frequenz und bestimmten Tastverhältnis sein. In dem nachfolgenden Programmschritt 33 wird das Leerlaufkontaktsignal von logisch Eins auf logisch Null gesetzt. Dies geschieht nach einer bestimmten Wartezeit, in der die angelegten Signale einschwingen können. Die fallende Flanke auf der Leerlaufkontaktleitung signalisiert dem Steuergerät die Gültigkeit der angelegten Eingangssignale. Danach wird im Prüfprogramm ständig eine Abfrage 34 der Zündsignalausgangsleitung 17 durchgeführt. Erkennt das Prüfprogramm eine fallende Flanke auf der Zündsignalausgangsleitung 17, so erkennt das Prüfprogramm damit, daß die für diesen Prüfschritt angelegten Eingangssignale von dem Steuergerät 10 verarbeitet wurden. Kommt diese Flanke nach einer bestimmten Zeitgrenze nicht, so wird das Prüfprogramm abgebrochen und das Steuergerät ebenfalls aus der Serienfertigung entfernt. In den nächsten Programmschritten 35 und 36 gibt der Prüfrechner 8 mit Hilfe der Simulations- und Meßeinrichtung 11 Rechtecksignale mit den - für diesen Prüfschritt vorgesehenen - Frequenzen und Tastverhältnissen an die - für diesen Prüfschritt vorgesehenen - Eingänge des Steuergerätes 10 aus. Diese Signale sind nicht auf Rechtecksignale beschränkt, sondern es könnten ebenfalls auch weitere alternierende Signale, wie Sägezahn- oder Dreiecksignale verwendet werden. Danach wird in dem Programmschritt 37 eine Zeitvariable auf Null gesetzt. In dem Programmschritt 38 und 39 wird der momentane Ausgangswert auf der für diesen Prüfschritt vorgesehenen Ausgangsleitung erfaßt und zusammen mit dem momentanen Wert der Zeitvariablen im Prüfrechner 8 abgespeichert. Der Wert der Zeitvariablen wird in dem nachfolgenden Programmschritt 40 um den Wert, der der inzwischen abgelaufenen Zeit entspricht, erhöht. Mit Hilfe der Abfrage 41 wird geprüft, ob die für diesen Prüfschritt vorgesehene Zeit zur Anlegung des Rechtecksignals schon überschritten ist. Ist dies der Fall, so wird der Rechteckgenerator 13 gestoppt (Programmschritt 42) und die Leerlaufkontakteingangsleitung 18 auf logisch Eins gesetzt (Programmschritt 43). Ist dies nicht der Fall, so werden die Programmschritte 37 - 41 wiederholt. Die nachfolgende Abfrage 46 dient zur Abfrage des Prüfschrittzählers. Ist der in der Prüfvorschrift angegebene Wert für die Anzahl der durchzuführenden Prüfschritte noch nicht überschritten, so werden die Programmschritte 31 - 46 wiederholt. Andernfalls wird das Programm mit Programmschritt 47 fortgeführt. Darin gibt der Prüfrechner 8 einen Befehl zur Abgabe der während der Prüfschritte in dem Steuergerät 10 abgelegten Verarbeitungsergebnisse an das Steuergerät 10 über den seriellen Bus 19 ab. Daraufhin werden die während der Prüfung im Speicher 9 des Steuergerätes 10 abgelegten Daten über den seriellen Bus 19 vom Steuergerät 10 ausgegeben und im Programmschritt 48 im Speicher des Prüfrechners 8 abgelegt. In dem Programmschritt 49 werden die vom Steuergerät 10 übermittelten Meßwerte der einzelnen Prüfschritte mit den für diese Prüfschritte vorgesehenen Sollwerten verglichen. Der Programmschritt 50 dient sodann zur Ausgabe der Vergleichsergebnisse. Im Programmschritt 51 wird das Ergebnis einer Speicherüberprüfung ausgegeben. Programmschritt 52 dient zur Auswertung der in dem Programmschritt 39 im Speicher des Prüfrechners abgelegten Meßwerte und Zeiten. Der Auswertevorgang wird in der Beschreibung der Figur 5 genauer dargelegt. Programmschritt 53 dient zur Ausgabe der Ergebnisse dieser Auswertung. Der Prüfvorgang wird vom Prüfrechner 8 durch Trennung der Versorgungsspannung vom Steuergerät 10 im Programmschritt 54 beendet.

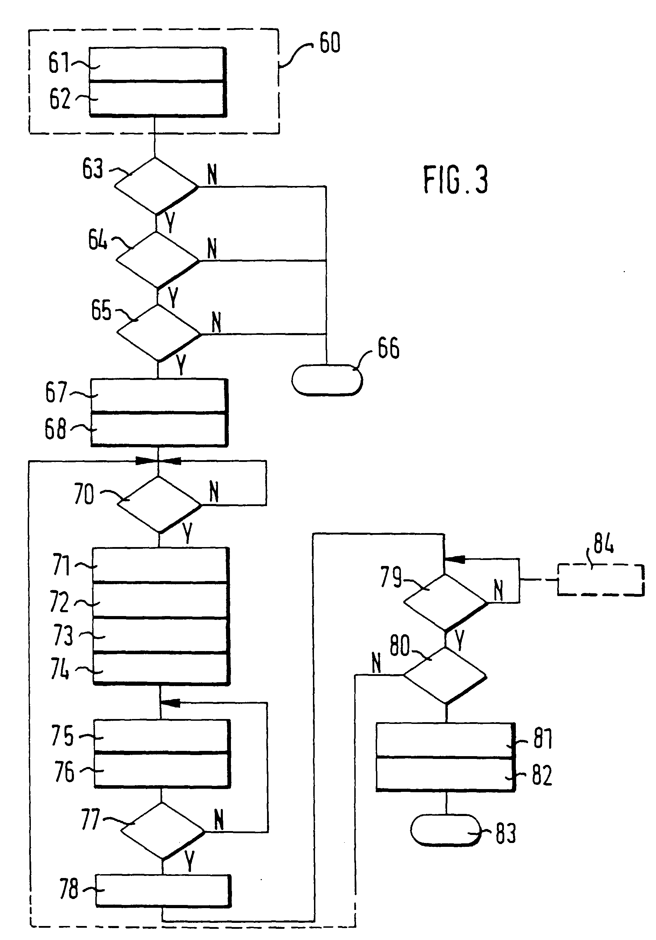

Im folgenden wird nun der Ablauf der Prüfung seitens des Steuergerätes 10 anhand des Struktogramms in Figur 3 erläutert. Nach dem Anschluß des Steuergerätes 10 an die Prüfeinrichtung 7 wird das Steuergerät 10 von der Prüfeinrichtung 7 her mit Spannung versorgt. Es führt dann die erforderlichen Selbsttests und Initialisierungen wie im normalen Nutzbetrieb aus und arbeitet dann das Nutzprogramm ab. Diese Vorgänge stellt der Programmschritt 61 dar. Im Programmschritt 62 führt das Steuergerät 10 die Kommunikation mit dem Prüfrechner 8 über den seriellen Bus 19 durch. Dazu gehört ebenfalls die Anforderung vom Prüfrechner 8 das Programm im Steuergerät aufzurufen. Der Programmteil 60 ist also nicht Teil des im Steuergerät 10 abgelegten Testprogramms, sondern dient vielmehr zur Inbetriebnahme des Steuergerätes 10 und zur Einleitung der Prüfung. Die Abfragen 63 - 65 sind Teil des Testprogramms. Sie dienen zur Überprüfung, ob der Einsprung in das Testprogramm erlaubt war, d. h., ob die schon im Programmschritt 30 der Figur 2 erwähnten Eingangswerte vom Prüfrechner 8 an das Steuergerät 10 angelegt wurden. Abfrage 63 prüft daher, ob an dem Drehzahleingang 14 eine Frequenz von 266,6 Hz anliegt. Liegt dieser Wert nicht an, so wird das Testprogramm im Programmschritt 66 abgebrochen und zum Nutzprogramm zurückgekehrt. Bei Anliegen des abgefragten Wertes wird in Abfrage 64 geprüft, ob am Geschwindigkeitseingang eine Frequenz von 133,3 Hz anliegt. Bei negativem Abfrageergebnis wird wieder zum Programmschritt 66 verzweigt. Bei positivem Abfrageergebnis wird in Abfrage 65 das Verhältnis der beiden zuvor überprüften Eingangswerte gebildet und auf den Wert 2 geprüft. Liegt am Drehzahleingang nicht die doppelte Frequenz, wie am Geschwindigkeitseingang, so wird ebenfalls zum Programmschritt 66 verzweigt. Andernfalls wird das Testprogramm mit Programmschritt 67 fortgeführt. Darin sendet das Steuergerät 10 eine Prüfbereitschaftsmeldung über den seriellen Bus 19 an den Prüfrechner 8 zurück. Im folgenden Programmschritt 68 führt das Steuergerät 10 einen Test des Speichers 9 des Steuergerätes 10 und eine für die Prüfung notwendige Initialisierung durch. Die Ergebnisse der Speicherüberprüfung werden anschließend im flüchtigen Teil 5 des Speichers 9 des Steuergerätes 10 abgelegt.

Bei der Initialisierung werden unter anderem der Speicher 9 neu eingeteilt und bestimmte Kontrollvariablen gesetzt. Bei der Speichereinteilung wird insbesondere der Bereich des Stapelspeichers von dem Adressbereich im Nutzprogramm auf einen anderen Bereich im flüchtigen Teil 5 des Speichers 9 gesetzt. Als Kontrollvariable kann zum Beispiel ein vom Nutzprogramm nicht genutzter Speicherplatz mit einem bestimmten Wert, zum Beispiel 5A Hex gefüllt werden. Desweiteren wird eine Variable für einen Prüfschrittzähler auf den Wert Null gesetzt. Im Programmschritt 70 erfolgt eine Abfrage, ob an dem Leerlaufkontakteingang eine logische Null anliegt. Ist dies der Fall, so erkennt das Testprogramm, daß der Prüfrechner 8 den ersten Prüfschritt einleitet. Liegt dieser Wert noch nicht am Leerlaufkontakteingang an, wiederholt das Steuergerät 10 die Abfrage 70. Es entsteht so eine Programmschleife, die solange vom Steuergerät 10 abgearbeitet wird, bis der Prüfrechner 8 den ersten Prüfschritt über den Leerlaufkontakteingang 18 anfordert. Zur Abarbeitung des Prüfschrittes wird im Programmschritt 71 dann als erstes der Prüfschrittzähler inkrementiert. Danach verarbeitet das Steuergerät 10 die an die Eingänge angelegten Meßwerte. Diese wurden vom Prüfrechner 8 angelegt und durch Setzen des Leerlaufkontakteingangs 18 auf logisch Null für gültig erklärt. Die Verarbeitung dieser angelegten Werte geschieht durch die Eingangsschaltungen des Steuergerätes 10. Bei der Verarbeitung werden keine Programmteile und/oder Daten des Nutzprogramms verwendet. Sie ist lediglich durch den Aufbau des Steuergeräts vorgegeben. Da als Eingangssignale auch analoge Signale verwendet werden, werden diese erst vom Steuergerät 10 einer A/D-Wandlung unterworfen. Dies geschieht im Programmschritt 72. Im Programmschritt 73 werden dann die durch die Eingangsschaltungen verarbeiteten Werte, die dann sämtlich digital vorliegen, im Speicher 9 abgelegt.

Zur späteren Zuordnung dieser Werte zum jeweiligen Prüfschritt wird der Stand des Prüfschrittzählers ebenfalls im Speicher 9 abgespeichert. Nach Durchführung dieses Programmschrittes wird die Zündsignalausgangsleitung 17 vom Steuergerät 10 auf logisch Null gesetzt. Dies geschieht im Programmschritt 74. Damit wird dem Prüfrechner 8 signalisiert, daß die angelegten Eingangswerte verarbeitet wurden. Im Programmschritt 75 wird der momentane Wert auf der Drehzahleingangsleitung 14 eingelesen und im Programmschritt 76 direkt an die Diagnoselampeausgangsleitung 15 ausgegeben. Es könnten aber auch andere Kombinationen von Ein-Ausgangsleitungen, wie Geschwindigkeitseingang und Drosselklappen-Anstellmotor-Ausgang, verwendet werden. Diese beiden Programmschritte werden dann in einer Programmschleife solange abgearbeitet, bis in der Abfrage 77 ein logisch Eins Zustand auf der Leerlaufkontakteingangsleitung 18 erkannt wird. Im Programmschritt 78 wird dann der Zündungssignalausgang 17 auf logisch Eins gesetzt. Mit diesem Signal wird dem Prüfrechner 8 die Beendigung eines Prüfschrittes signalisiert. Bevor nun weitere Prüfschritte abgearbeitet werden, wird im Prüfschritt 79 überprüft, ob die Prüfung korrekt initialisiert wurde. Dabei wird die im Prüfschritt 68 gesetzte Kontrollvariable und der Wert des Stapelzeigers mit dem bei der Initialisierung gesetzten Werten verglichen. Diese Überprüfung hat den Zweck, eine unbeabsichtigte Einleitung der Prüfung zum Beispiel durch EMV-Störungen zu erkennen. Dies dient zur Sicherung des Fahrbetriebes, wie auch zum Schutz des Motors, da die Ansteuerung der Ausgänge insbesondere des Zündungssignalausgangs 17 während der Prüfung sich schädigend auf den Motor auswirken könnte. War die Prüfung nicht korrekt initialisiert, wird die Abfrage 79 wiederholt. Dadurch entsteht dann eine Endlosschleife, die nach kurzer Zeit (zum Beispiel 15 Millisekunden) vom Reset einer "Watch-dog"-Schaltung abgebrochen wird (Programmschritt 84). War die Prüfung korrekt initialisiert, so prüft das Steuergerät 10 in der Abfrage 80, ob eine Aufforderung zur Datenausgabe, der während des Prüfschrittes abgespeicherten Daten vom Prüfrechner 8 anliegt. Diese Aufforderung wird vom Prüfrechner 8 nach Beendigung aller Prüfschritte über den seriellen Bus 19 durch Übermittlung eines Befehlsblockes geschickt. Bei Nichtanliegen dieser Aufforderung werden die Programmschritte 70 bis 80 wiederholt.

Nach der Aufforderung zur Datenausgabe werden die Daten im Programmschritt 81 und 82 an den Prüfrechner 8 über den seriellen Bus 19 übermittelt. Dabei werden im Programmschritt 81 die, während der einzelnen Prüfschritte im Speicher 9 abgelegten, Eingangswerte mit den jeweiligen Prüfschrittzählerständen blockweise übertragen. Jeder Block enthält die Meßwerte eines Prüfschrittes. Im Programmschritt 82 wird noch das Ergebnis der Speicherüberprüfung vom Programmschritt 67 in einem Block an den Prüfrechner 8 übermittelt. Nach der Datenübertragung wird das Steuergerät im Programmschritt 83 in einen Wartezustand versetzt. Dieser Zustand wird bis zur Abschaltung der Versorgungsspannung seitens des Prüferrechners 8 eingehalten.

Figur 4 zeigt die Steuerung eines Prüfschrittes mit Hilfe einer Eingangs- und Ausgangsleitung des Steuergerätes 10. Das Signal 24 wird dabei vom Prüfrechner 8 über die Leerlaufkontakteingangsleitung 18 dem Steuergerät 10 zugeführt. Das Signal 25 wird dabei vom Steuergerät 10 über die Zündsignalausgangsleitung dem Prüfrechner 8 zugeführt. Ein Prüfschritt beginnt damit, daß der Prüfrechner 8 an bestimmte Eingangsleitungen des Steuergerätes bestimmte Signale anlegt. Dies ist im Programmschritt 32 erläutert worden. Während der Zeit t_{E} läßt der Prüfrechner 8 die angelegten Eingangssignale einschwingen. Nach Ablauf der Zeit t_{E} legt der Prüfrechner 8 die Leerlaufkontakteingangsleitung auf logisch Null. Diese Flanke 20 wird vom Steuergerät 10 erkannt. Das Steuergerät 10 wertet dieses Ereignis als Aufforderung zur Verarbeitung der an den Eingängen anliegenden Signale. In der Zeit t_{L} verarbeitet das Steuergerät 10 diese angelegten Signale wie in den Prüfschritten 72 und 73 angegeben. Danach legt das Steuergerät 10 seinerseits die Zündsignalausgangsleitung 17 von logisch Eins auf logisch Null. Diese Flanke 21 wird wiederum vom Prüfrechner 8 erkannt, der daraufhin an bestimmte Eingänge bestimmte Rechtecksignale anlegt. Die Rechtecksignale werden während der Zeit t_{D} angelegt und vom Steuergerät 10 wie in den Programmschritten 75 und 76 beschrieben und ebenfalls vom Prüfrechner 8 wie in den Programmschritten 37 bis 41 beschrieben, verarbeitet. Nach dieser Zeit t_{D} legt der Prüfrechner 8 die Leerlaufkontakteingangsleitung von logisch Null nach logisch Eins wie in Flanke 22 gezeigt. Damit wird das Ende des Prüfschrittes signalisiert. Nach Erkennung dieser Flanke 22 legt das Steuergerät 10 seinerseits die Zündungssignalausgangsleitung 17 von logisch Null nach logisch Eins. Die Flanke 23 ist aufgrund der Verarbeitungszeit im Steuergerät 10 um die Zeit t_{V} verzögert. Diese Vorgänge laufen für die einzelnen Prüfschritte in wiederholter Weise ab. Da vom Prüfrechner 8 die Zeit t_{E} vorhergebbar ist, ergibt sich die Möglichkeit, nach diesem Verfahren auch dynamische Eingangsmessungen durchzuführen. Das geschieht indem in mehrere Prüfschritten die gleichen Eingangssignale an das Steuergerät 10 angelegt werden und die Zeit zwischen Anlegung und Gültigkeitserklärung der Signale sukzessive erhöht werden. Im Steuergerät 10 wird dann ein zeitliches Verhalten dieser Signale im Speicher 9 abgelegt. Das Zeitverhalten ist aufgrund der Speichergröße des flüchtigen Speichers 9 im Steuergerät 10 nur begrenzt darstellbar.

In Figur 5 ist die Auswertung der angelegten und ausgegebenen Rechtecksignale verdeutlicht. Das Signal 90 stellt ein mögliches Rechtecksignal für einen Prüfschritt an einem Eingang des Steuergerätes dar. Das Signal 91 stellt das Verarbeitungsergebnis dieses Rechtecksignals, welches an den Prüfrechner 8 über eine bestimmte Ausgangsleitung ausgegeben wird, dar. Die einzelnen Flanken des Signals 91 sind aufgrund der Verarbeitungszeiten des Steuergerätes 10 gegenüber den Flanken des Signals 90 um die Zeiten Δt₁ bis Δt₄ verzögert. Die Verzögerungszeiten Δt₁ bis Δt₄ sollten z.B. im Regelfall ca. 200 Mikrosekunden betragen. Liegen sie bei mehr als 41 ms, so ist eine ordnungsgemäße Funktion des Steuergerätes nicht mehr möglich und das Steuergerät wird nicht als gut befunden. Ebenfalls können an der Signalform des Signals 91 Veränderungen im Vergleich zum Signal 90 auftreten. Durch Vermessung Abschaltspitzen 93 und 96 sowie der Sättigungsspannungen 92, 94 und 95 und Vergleich mit dem Signal 90 läßt sich Aufschluß über die Qualität der Ausgangsschaltungen des Steuergerätes gewinnen.

## Patentansprüche

1. Verfahren zur Prüfung von Steuergeräten (10), insbesondere von Steuergeräten (10) zur Steuerung von Verbrennungsmotoren, mit einem Nutzprogramm und einem Testprogramm, wobei beim Testprogramm von einer Prüfeinrichtung (7) Meßwerte an Eingängen (16) des Steuergeräts angelegt werden, wobei die aus den Meßwerten vom Steuergerät (10) ermittelten Werte an die Prüfeinrichtung (7) übermittelt und dort auf Richtigkeit geprüft werden, dadurch gekennzeichnet, daß beim Testprogramm dem Steuergerät (10) die Gültigkeit der anliegenden Meßwerte mitgeteilt wird, indem die Prüfeinrichtung (7) ein erstes Signal auf mindestens eine weitere Eingangsleitung des Steuergeräts gibt, daß die anliegenden Meßwerte vom Steuergerät (10) verarbeitet und die Verarbeitungsergebnisse in einem Speicher (9) abgelegt werden, daß nach Beendigung der Verarbeitung vom Steuergerät (10) ein zweites Signal auf mindestens einer Ausgangsleitung (17) des Steuergeräts (10) abgegeben wird, und daß beim Nutzprogramm das Steuergerät (10) auf der mindestens einen weiteren Eingangsleitung (18) Signale einliest und auf der mindestens einen Ausgangsleitung (17) Signale ausgibt.

2. Verfahren nach Anspruch 1, dadurch gekennzeichnet, daß die im Speicher (9) abgelegten Verarbeitungsergebnisse am Ende der Prüfung an die Prüfeinrichtung übertragen werden.

3. Verfahren zur Prüfung von Steuergeräten (10), insbesondere von Steuergeräten (10) zur Steuerung von Verbrennungsmotoren, mit einem Nutzprogramm und einem Testprogramm, wobei beim Testprogramm von einer Prüfeinrichtung (7) Meßwerte an Eingängen (16, 14) des Steuergeräts angelegt werden, wobei die aus den Meßwerten vom Steuergerät (10) ermittelten Werte an die Prüfeinrichtung (7) übermittelt und dort auf Richtigkeit geprüft werden, dadurch gekennzeichnet,
daß beim Testprogramm von der Prüfeinrichtung auf mindestens einer weiteren Eingangsleitung (14) des Steuergerätes (10) ein alternierendes Signal angelegt wird, daß dieses Signal vom Steuergerät (10) abgefragt wird, daß das Abfrageergebnis an mindestens einer Ausgangsleitung (15) des Steuergerätes (10) abgegeben wird, daß der zeitliche Verlauf von dem Signal an der mindestens einen Ausgangsleitung (15) von der Prüfeinrichtung (7) erfaßt und in bezug auf den zeitlichen Verlauf zum Signal an der mindestens einen Eingangsleitung (14) ausgewertet wird, und daß beim Nutzprogramm das Steuergerät (10) auf der mindestens einen weiteren Eingangsleitung (14) Signale einliest und auf der mindestens einen Ausgangsleitung (15) Signale ausgibt.

4. Verfahren nach Anspruch 3, dadurch gekennzeichnet, daß die Abfrage des an mindestens einem Eingang (14) des Steuergerätes (10) anliegenden alternierenden Signales und die Ausgabe des Abfrageergebnisses an einen bestimmten Ausgang (15) von einem Unterprogramm des Testprogramms durchgeführt wird, welches zu bestimmten Zeiten aufgerufen und vom Steuergerät (10) abgearbeitet wird.

5. Verfahren nach einem der vorhergehenden Ansprüche, dadurch gekennzeichnet, daß während der Einleitung der Prüfung an bestimmte Eingänge des Steuergerätes (10) mindestens einen, im normalen Nutzbetrieb unplausible Meßwerte angelegt werden, die von dem Testprogramm erfaßt und auf Richtigkeit geprüft werden und bei Unrichtigkeit zum Abbruch des Testprogramms führen.

6. Verfahren nach einem der vorhergehenden Ansprüche, dadurch gekennzeichnet, daß das Testprogramm die Funktionsfähigkeit des Speichers (9) des Steuergerätes überprüft und die Prüfergebnisse im Speicher (9) ablegt.

7. Verfahren nach einem der vorhergehenden Ansprüche, dadurch gekennzeichnet, daß zu Beginn der Prüfung eine Initialisierung (67) des Steuergerätes (10) vorgenommen wird, wobei vom Testprogramm bestimmte Daten auf einen freien Speicherplatz des Speichers (9) des Steuergerätes und/oder in bestimmte Register des Steuergerätes gespeichert werden, daß während des Ablaufs der Prüfung vom Testprogramm der Inhalt des Speicherplatzes und/oder der Register auf Richtigkeit überprüft wird und daß bei Unrichtigkeit der auf dem Speicherplatz und/oder der Register abgelegten Werte ein Abbruch des Testprogramms erfolgt.

8. Prüfeinrichtung zur Prüfung von Steuergeräten (10), insbesondere von Steuergeräten (10) zur Steuerung von Verbrennungsmotoren, mit einem Nutzprogramm und einem Testprogramm, wobei beim Testprogramm von der Prüfeinrichtung (7) Meßwerte an Eingängen (16) des Steuergeräts angelegt werden, wobei die aus den Meßwerten vom Steuergerät (10) ermittelten Werte an die Prüfeinrichtung (7) übermittelt und dort auf Richtigkeit geprüft werden, dadurch gekennzeichnet,
daß beim Testprogramm dem Steuergerät (10) die Gültigkeit der anliegenden Meßwerte mitgeteilt wird, indem die Prüfeinrichtung (7) ein erstes Signal auf mindestens eine weitere Eingangsleitung des Steuergeräts gibt, daß die anliegenden Meßwerte vom Steuergerät (10) verarbeitet und die Verarbeitungsergebnisse in einem Speicher (9) abgelegt werden, daß nach Beendigung der Verarbeitung vom Steuergerät (10) ein zweites Signal auf mindestens einer Ausgangsleitung (17) des Steuergeräts (10) abgegeben wird, und daß beim Nutzprogramm das Steuergerät (10) auf der mindestens einen weiteren Eingangsleitung (18) Signale einliest und auf der mindestens einen Ausgangsleitung (17) Signale ausgibt.

9. Prüfeinrichtung nach Anspruch 8, dadurch gekennzeichnet, daß die Prüfeinrichtung bei Eintreffen des zweiten Signals die nächsten Meßwerte anlegt und danach das erste Signal erneut ausgibt.

10. Prüfeinrichtung nach Anspruch 9, dadurch gekennzeichnet, daß vor jeder Abgabe von Meßwerten ein Zähler erhöht wird, der die Anzahl der abgegebenen Meßwerte enthält.

11. Prüfeinrichtung nach Anspruch 10, dadurch gekennzeichnet, daß nach Erreichen eines bestimmten Wertes des Zählers die Verarbeitungsergebnisse vom Steuergerät angefordert werden.

12. Prüfeinrichtung nach einem der Ansprüche 10 oder 11, dadurch gekennzeichnet, daß im Steuergerät ebenfalls ein Zähler vor jeder Verarbeitung von angelegten Meßwerten erhöht wird und der jeweilige Zählerstand mit den zugehörigen Verarbeitungsergebnissen im Speicher (9) abgespeichert wird.

13. Prüfeinrichtung nach Anspruch 12, dadurch gekennzeichnet, daß am Ende der Prüfung die Verarbeitungsergebnisse zusammen Mit den jeweiligen Zählerständen, nach Aufforderung von dem Prüfrechner, an den Prüfrechner übermittelt werden und mit den zu den jeweiligen Zählerständen zugehörigen Sollwerten verglichen werden.

14. Prüfeinrichtung nach Anspruch 13, dadurch gekennzeichnet, daß die Prüfergebnisse des Funktionsfähigkeitstests des Speichers (9) des Steuergerätes an den Prüfrechner übermittelt und anschließend ausgewertet werden.

15. Prüfeinrichtung zur Prüfung von Steuergeräten (10), insbesondere von Steuergeräten (10) zur Steuerung von Verbrennungsmotoren, mit einem Nutzprogramm und einem Testprogramm, wobei beim Testprogramm von der Prüfeinrichtung (7) Meßwerte an Eingängen (16, 14) des Steuergeräts angelegt werden, wobei die aus den Meßwerten vom Steuergerät (10) ermittelten Werte an die Prüfeinrichtung (7) übermittelt und dort auf Richtigkeit geprüft werden, dadurch gekennzeichnet,
daß beim Testprogramm von der Prüfeinrichtung (7) auf mindestens einer weiteren Eingangsleitung (14) des Steuergerätes (10) ein alternierendes Signal angelegt wird, daß dieses Signal vom Steuergerät (10) abgefragt wird, daß das Abfrageergebnis an mindestens einer Ausgangsleitung (15) des Steuergerätes (10) abgegeben wird, daß der zeitliche Verlauf von dem Signal an der mindestens einen Ausgangsleitung (15) von der Prüfeinrichtung (7) erfaßt und in bezug auf den zeitlichen Verlauf zum Signal an der mindestens einen Eingangsleitung (14) ausgewertet wird, und daß beim Nutzprogramm das Steuergerät (10) auf der mindestens einen weiteren Eingangsleitung (14) Signale einliest und auf der mindestens einen Ausgangsleitung (15) Signale ausgibt.

16. Prüfeinrichtung nach einem der Ansprüche 8 bis 15, dadurch gekennzeichnet, daß zur Überwachung des Prüfvorganges die Verarbeitungszeit des Steuergerätes gemessen wird und bei Ausbleiben einer Reaktion vom Steuergerät nach Überschreitung einer vorbestimmten Zeit ein Abbruch des Testprogramms erfolgt.

17. Prüfeinrichtung nach einem der Ansprüche 8 bis 16, dadurch gekennzeichnet, daß die Datenübertragung zwischen Steuergerät (10) und Prüfrechner (8) über einen seriellen Bus (19) stattfindet.

## Claims

1. Method for testing control apparatus (10), in particular control apparatus (10) for controlling internal combustion engines, having a utility program and a test program, in the case of the test program measured values being applied by a testing device (7) to inputs (16) of the control apparatus, the values determined from the measured values by the control apparatus (10) being communicated to the testing device (7) and tested there for correctness, characterized in that, in the case of the test program, the control apparatus (10) is informed as to the validity of the measured values present, in that the testing device (7) applies a first signal to at least one further input line of the control apparatus, in that the measured values present are processed by the control apparatus (10) and the processing results are stored in a memory (9), in that following the completion of the processing a second signal is output by the control apparatus (10) on at least one output line (17) of the control apparatus (10), and in that in the case of the utility program, the control apparatus (10) reads in signals on the at least one further input line (18) and outputs signals on the at least one output line (17).

2. Method according to Claim 1, characterized in that the processing results stored in the memory (9) are transmitted to the testing device at the end of the test.

3. Method for testing control apparatus (10), in particular control apparatus (10) for controlling internal combustion engines, having a utility program and a test program, in the case of the test program measured values being applied by a testing device (7) to inputs (16, 14) of the control apparatus, the values determined from the measured values by the control apparatus (10) being communicated to the testing device (7) and tested there for correctness, characterized in that, in the case of the test program, an alternating signal is applied by the testing device to at least one further input line (14) of the control apparatus (10), in that this signal is interrogated by the control apparatus (10), in that the interrogation result is output on at least one output line (15) of the control apparatus (10), in that the variation with time of the signal on the at least one output line (15) is registered by the testing device (7) and is evaluated with respect to the variation with time relating to the signal on the at least one input line (14), and in that, in the case of the utility program, the control apparatus (10) reads in signals on the at least one further input line (14) and outputs signals on the at least one output line (15).

4. Method according to Claim 3, characterized in that the interrogation of the alternating signal present on at least one input (14) of the control apparatus (10) and the output of the interrogation result on a specific output (15) is carried out by a subprogram of the test program, which subprogram is called up at specific times and executed by the control apparatus (10).

5. Method according to one of the preceding claims, characterized in that, during the initiation of the test, at least one measured value which is implausible in normal utility operation is applied to specific inputs of the control apparatus (10), said measured values being registered by the test program and tested for correctness and, in the case of incorrectness, leading to abortion of the test program.

6. Method according to one of the preceding claims, characterized in that the test program checks the serviceability of the memory (9) of the control apparatus and stores the test results in the memory (9).

7. Method according to one of the preceding claims, characterized in that, at the beginning of the test, an initialization (67) of the control apparatus (10) is undertaken, specific data being stored by the test program at a free memory location of the memory (9) of the control apparatus and/or in specific registers of the control apparatus, in that during the sequence of the test the content of the memory location and/or of the register is checked by the test program for correctness, and in that in the case of incorrectness of the values stored at the memory location and/or in the register the test program is aborted.

8. Testing device for testing control apparatus (10), in particular control apparatus (10) for controlling internal combustion engines, having a utility program and a test program, in the case of the test program measured values being applied by the testing device (7) to inputs (16) of the control apparatus, the values determined from the measured values by the control apparatus (10) being communicated to the testing device (7) and tested there for correctness, characterized in that, in the case of the test program, the control apparatus (10) is informed as to the validity of the measured values present, in that the testing device (7) applies a first signal to at least one further input line of the control apparatus, in that the measured values present are processed by the control apparatus (10) and the processing results are stored in a memory (9), in that following the completion of the processing a second signal is output by the control apparatus (10) on at least one output line (17) of the control apparatus (10), and in that in the case of the utility program, the control apparatus (10) reads in signals on the at least one further input line (18) and outputs signals on the at least one output line (17).

9. Testing device according to Claim 8, characterized in that, when the second signal arrives, the testing device applies the next measured values and subsequently outputs the first signal anew.

10. Testing device according to Claim 9, characterized in that, before each output of measured values, a counter is incremented which contains the number of measured values output.

11. Testing device according to Claim 10, characterized in that, after reaching a specific value of the counter, the processing results are requested by the control apparatus.

12. Testing device according to one of Claims 10 or 11, characterized in that, in the control apparatus, a counter is likewise incremented before each processing of applied measured values and the respective counter reading is stored in the memory (9) together with the associated processing results.

13. Testing device according to Claim 12, characterized in that, at the end of the test, the processing results, together with the respective counter readings, following a request by the test computer, are communicated to the test computer and are compared with the desired values associated with the respective counter readings.

14. Testing device according to Claim 13, characterized in that the test results from the serviceability test of the memory (9) of the control apparatus are transmitted to the test computer and subsequently evaluated.

15. Testing device for testing control apparatus (10), in particular control apparatus (10) for controlling internal combustion engines, having a utility program and a test program, in the case of the test program measured values being applied by the testing device (7) to inputs (16, 14) of the control apparatus, the values determined from the measured values by the control apparatus (10) being communicated to the testing device (7) and tested there for correctness, characterized in that, in the case of the test program, an alternating signal is applied by the testing device (7) to at least one further input line (14) of the control apparatus (10), in that this signal is interrogated by the control apparatus (10), in that the interrogation result is output on at least one output line (15) of the control apparatus (10), in that the variation with time of the signal on the at least one output line (15) is registered by the testing device (7) and is evaluated with respect to the variation with time relating to the signal on the at least one input line (14), and in that, in the case of the utility program, the control apparatus (10) reads in signals on the at least one further input line (14) and outputs signals on the at least one output line (15).

16. Testing device according to one of Claims 8 to 15, characterized in that, for the purpose of monitoring the testing procedure, the processing time of the control apparatus is measured and, in the absence of a reaction from the control apparatus, the test program is aborted after exceeding a predetermined time.

17. Testing device according to one of Claims 8 to 16, characterized in that the data transmission between control apparatus (10) and test computer (8) takes place via a serial bus (19).

## Revendications

1. Procédé pour contrôler des appareils de commande (10), en particulier des appareils de commande (10) servant à commander des moteurs à combustion interne, avec un programme d'utilisation et un programme d'essai, dans lequel lors du programme d'essai on applique des valeurs de mesure par un dispositif de contrôle (7) aux entrées (16) de l'appareil de commande, les valeurs déterminées par l'appareil de commande (10) à partir des valeurs de mesure étant transmises au dispositif de contrôle (7) et leur exactitude étant contrôlée à cet endroit,
caractérisé en ce que
lors du programme d'essai on informe l'appareil de commande (10) de la validité des valeurs de mesure appliquées, en faisant délivrer par le dispositif de contrôle (7) un premier signal à au moins une autre ligne d'entrée de l'appareil de commande, en ce qu'on retraite les valeurs de mesure appliquées par l'appareil de commande (10) et en déposant les résultats du retraitement dans une mémoire (9), en ce qu'après la fin du retraitement on délivre par l'appareil de commande (10) un second signal à au moins une ligne de sortie (17) de l'appareil de commande (10), et en ce que lors du programme d'utilisation, l'appareil de commande (10) enregistre des signaux sur au moins une autre ligne d'entrée (18) et délivre des signaux à au moins la ligne de sortie (17).

2. Procédé selon la revendication 1,
caractérisé en ce que
les résultats du retraitement déposés dans la mémoire (9) sont transmis à la fin du contrôle au dispositif de contrôle

3. Procédé de contrôle d'appareils de commande (10), en particulier des appareils de commande (10) servant à commander des moteurs à combustion interne, avec un programme d'utilisation et un programme d'essai, dans lequel lors du programme d'essai on applique des valeurs de mesure par un dispositif de contrôle (7) aux entrées (16, 14) de l'appareil de commande, les valeurs déterminées par l'appareil de commande (10) à partir des valeurs de mesure étant transmises au dispositif de contrôle (7) et leur exactitude étant contrôlée à cet endroit,
caractérisé en ce que
lors du programme d'essai on applique un signal alternatif par le dispositif de contrôle à au moins une autre ligne d'entrée (14) de l'appareil de commande (10), en ce que ce signal est interrogé par l'appareil de commande (10), en ce que le résultat de l'interrogation est délivré à au moins une ligne de sortie (15) de l'appareil de commande (10), en ce que le déroulement dans le temps du signal sur au moins une ligne de sortie (15) est détecté par le dispositif de contrôle (7) et est exploité en ce qui concerne le déroulement dans le temps sur au moins une ligne d'entrée (14) et en ce que lors du programme d'utilisation, l'appareil de commande (10) enregistre sur au moins une autre ligne d'entrée (14) des signaux et délivre sur au moins une autre ligne de sortie (15) des signaux.

4. Procédé selon la revendication 3,
caractérisé en ce que
l'interrogation du signal alternatif appliqué sur au moins une entrée (14) de l'appareil de commande (10) et la délivrance du résultat de l'interrogation à une sortie déterminée (15) est effectuée par un sous-programme du programme d'essai, qui est appelé à des instantes déterminés et qui est exploité par l'appareil de commande (10).

5. Procédé selon l'une des revendications précédentes,
caractérisé en ce que
pendant l'introduction du contrôle aux entrées déterminées de l'appareil de commande (10), on applique au moins l'une des valeurs de mesure non plausibles en fonctionnement normal, qui sont détectées par le programme d'essai et dont l'exactitude est contrôlée et qui conduisent à la rupture du programme d'essai en cas d'inexactitude.

6. Procédé selon l'une des revendications précédentes,
caractérisé en ce que
le programme d'essai contrôle l'aptitude fonctionnelle de la mémoire (9) de l'appareil de commande et dépose les résultats du contrôle dans la mémoire (9).

7. Procédé selon l'une des revendications précédentes,
caractérisé en ce que
au début du contrôle on procède à une initialisation (67) de l'appareil de commande (10), des données déterminées par le programme d'essai étant mises en mémoire dans un emplacement libre de la mémoire (9) de l'appareil de commande et/ou dans des registres déterminés de l'appareil de commande, en ce que pendant le déroulement du contrôle par le programme d'essai on contrôle l'exactitude du contenu de l'emplacement de la mémoire et/ou des registres et en ce qu'en cas d'inexactitude des valeurs déposées à l'emplacement de la mémoire et/ou dans les registres une rupture du programme d'essai a lieu.

8. Dispositif de contrôle servant à contrôler des appareils de commande (10), en particulier des appareils de commande (10) servant à commander des moteurs à combustion interne, avec un programme d'utilisation et un programme d'essai, dans lequel lors du programme d'essai on applique des valeurs de mesure par un dispositif de contrôle (7) aux entrées (16) de l'appareil de commande, les valeurs déterminées par l'appareil de commande (10) à partir des valeurs de mesure étant transmises au dispositif de contrôle (7) et leur exactitude étant contrôlée à cet endroit,
caractérisé en ce que
lors du programme d'essai on informe l'appareil de commande (10) de la validité des valeurs de mesure appliquées, en faisant délivrer par le dispositif de contrôle (7) un premier signal à au moins une autre ligne d'entrée de l'appareil de commande, en ce qu'on retraite les valeurs de mesure appliquées par l'appareil de commande (10) et en déposant les résultats du retraitement dans une mémoire (9), en ce qu'après la fin du retraitement on délivre par l'appareil de commande (10) un second signal à au moins une ligne de sortie (17) de l'appareil de commande (10), et en ce que lors du programme d'utilisation, l'appareil de commande (10) enregistre des signaux sur au moins une autre ligne d'entrée (18) et délivre des signaux à au moins la ligne de sortie (17).

9. Dispositif de contrôle selon la revendication 8,
caractérisé en ce que
le dispositif de contrôle, lors de l'arrivée du second signal, applique les valeurs de mesure suivantes et délivre à nouveau ensuite le premier signal.

10. Dispositif de contrôle selon la revendication 9,
caractérisé en ce que
avant chaque délivrance des valeurs de mesure on augmente un compteur, qui contient le nombre des valeurs de mesure délivrées.

11. Dispositif de contrôle selon la revendication 10,
caractérisé en ce que
après avoir atteint une valeur déterminée du compteur, les résultats de retraitement sont réclamés par l'appareil de commande.

12. Dispositif de contrôle selon l'une des revendications 10 ou 11,
caractérisé en ce que
dans l'appareil de commande on augmente également un compteur avant chaque retraitement des valeurs de mesure appliquées et on met en mémoire la position respective du compteur avec les résultats correspondants du retraitement dans la mémoire (9).

13. Dispositif de contrôle selon la revendication 12,
caractérisé en ce que
à la fin du contrôle on transmet à l'ordinateur de contrôle les résultats du retraitement en même temps que les positions correspondantes du compteur, à la demande de l'ordinateur de contrôle, et on les compare avec les valeurs de consigne correspondant aux positions respectives du compteur.

14. Dispositif de contrôle selon la revendication 13,
caractérisé en ce que
l'on transmet les résultats de contrôle du test d'aptitude à fonctionner de la mémoire (9) de l'appareil de commande à l'ordinateur de contrôle et ensuite on les exploite.

15. Dispositif de contrôle pour contrôler des appareils de commande (10), en particulier des appareils de commande (10) servant à commander des moteurs à combustion interne, avec un programme d'utilisation et un programme d'essai, dans lequel lors du programme d'essai on applique des valeurs de mesure par un dispositif de contrôle (7) aux entrées (16, 14) de l'appareil de commande, les valeurs déterminées par l'appareil de commande (10) à partir des valeurs de mesure étant transmises au dispositif de contrôle (7) et leur exactitude étant contrôlée à cet endroit,
caractérisé en ce que
lors du programme d'essai on applique par le dispositif de contrôle (7) sur au moins une autre ligne d'entrée (14) de l'appareil de commande (10) un signal alternatif, en ce que ce signal est interrogé par l'appareil de commande (10), en ce que le résultat de l'interrogation est délivré à au moins une ligne de sortie (15) de l'appareil de commande (10), en ce que le déroulement dans le temps du signal est détecté sur au moins l'une des lignes de sortie (15) par le dispositif de contrôle (7) et est exploité en ce qui concerne le déroulement dans le temps sur l'une au moins des lignes d'entrées (14) et en ce que lors du programme d'utilisation, l'appareil de commande (10) enregistre sur au moins une autre ligne d'entrée (14) des signaux et délivre sur au moins l'une des lignes de sortie (15) des signaux.

16. Dispositif de contrôle selon l'une des revendications 8 à 15,
caractérisé en ce que
pour surveiller le processus de contrôle on mesure le temps de retraitement de l'appareil de commande et en cas d'absence de réaction de l'appareil de commande, une rupture du programme d'essai a lieu une fois passé un temps prédéterminé.

17. Dispositif de contrôle selon l'une des revendications 8 à 16,
caractérisé en ce que
la transmission des données entre l'appareil de commande (10) et l'ordinateur de contrôle (8) a lieu au moyen d'un bus en série (19).
